(19) Europäisches Patentamt
European Patent Office
Office européen des brevets

(11) **EP 4 582 304 A1**

(12) **EUROPEAN PATENT APPLICATION**

(43) Date of publication:
**09.07.2025 Bulletin 2025/28**

(21) Application number: **24150212.9**

(22) Date of filing: **03.01.2024**

(51) International Patent Classification (IPC):
**B60L 58/10** (2019.01)   **B60L 58/12** (2019.01)
**B60L 58/16** (2019.01)   **G01R 31/392** (2019.01)
**H01M 10/44** (2006.01)   **H01M 10/48** (2006.01)

(52) Cooperative Patent Classification (CPC):
**B60L 58/12; B60L 53/62; B60L 58/10; B60L 58/16;
G01R 31/392; H01M 10/44; H01M 10/441;
H01M 10/48; H01M 10/482**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Samsung SDI Co., Ltd.
Yongin-si, Gyeonggi-do 17084 (KR)**

(72) Inventors:
• **Janek, Alex
  8041 Graz (AT)**
• **Prossnigg, Florian
  8047 Graz (AT)**

(74) Representative: **Gulde & Partner
Patent- und Rechtsanwaltskanzlei mbB
Berliner Freiheit 2
10785 Berlin (DE)**

Remarks:
Amended claims in accordance with Rule 137(2) EPC.

(54) **METHOD FOR OPERATING A BATTERY PACK FOR ADJUSTING AN OPERATIONAL LIMIT FOR THE BATTERY PACK**

(57)   The present disclosure refers to a method for operating a battery pack, is provided. Thereby a current intermediate characteristic value characterizing an aging state degree of the battery pack is determined based on detected and/or obtained condition measurement signal. Afterwards, a comparison of the current intermediate characteristic value and a first predetermined value of the intermediate characteristic value is performed, wherein the first predetermined value includes a value of the intermediate characteristic value at which a predefined value of the aging state degree is undercut. Further, an operational limit for the battery pack is adjusted based on the comparison. The invention further relates to a battery system including a battery pack, the battery system being configured for performing the disclosed method.

FIG. 2

**Description**

**Field of the Disclosure**

The present disclosure relates to a method for operating a battery module. The present disclosure also relates to a battery system, the battery system being configured for performing the disclosed method, and an electric vehicle including the battery system.

**Technological Background**

Recently, vehicles for transportation of goods and peoples have been developed that use electric power as a source for motion. Such an electric vehicle is an automobile that is propelled permanently or temporarily by an electric motor, using energy stored in rechargeable batteries. An electric vehicle may be solely powered by batteries (Battery Electric Vehicle BEV) or may include a combination of an electric motor and, for example, a conventional combustion engine (Plugin Hybrid Electric Vehicle PHEV). BEVs and PHEVs use high-capacity rechargeable batteries, which are designed to give power for propulsion over sustained periods of time.

Generally, a rechargeable (or secondary) battery cell includes an electrode assembly including a positive electrode, a negative electrode, and a separator interposed between the electrodes. A solid or liquid electrolyte allows movement of ions during charging and discharging of the battery cell. The electrode assembly is located in a casing and electrode terminals, which are positioned on the outside of the casing, establish an electrically conductive connection to the electrodes. The shape of the casing may be, for example, cylindrical or rectangular.

A battery module is formed of a plurality of battery cells connected in series or in parallel. That is, the battery module is formed by interconnecting the electrode terminals of the plurality of battery cells depending on a required amount of power and in order to realize a high-power rechargeable battery.

Battery modules can be constructed in either a block design or in a modular design. In the block design each battery cell is coupled to a common current collector structure and a common battery management system and the unit thereof is arranged in a housing. In the modular design, pluralities of battery cells are connected together to form submodules and several submodules are connected together to form the battery module. In automotive applications, battery systems generally include a plurality of battery modules connected in series for providing a desired voltage.

A battery pack is a set of any number of (for example identical) battery modules or single battery cells. The battery modules, respectively battery cells, may be configured in a series, parallel or a mixture of both to deliver the desired voltage, capacity, and/or power density. Components of a battery pack include the individual battery modules, and the interconnects, which provide electrical conductivity between the battery modules.

A battery system may also include a battery management system (BMS), which is any suitable electronic system that is configured to manage the rechargeable battery cell, battery module, and battery pack, such as by protecting the batteries from operating outside their safe operating area, monitoring their states, calculating secondary data, reporting that data, controlling its environment, authenticating it and/or balancing it. For example, the BMS may monitor the state of the battery cell as represented by voltage (e.g., a total voltage of the battery pack or battery modules, and/or voltages of individual battery cells), temperature (e.g., an average temperature of the battery pack or battery modules, coolant intake temperature, coolant output temperature, or temperatures of individual battery cells), coolant flow (e.g., flow rate and/or cooling liquid pressure), and current. Additionally, the BMS may calculate values based on the above parameters, such as minimum and maximum cell voltage, state of charge (SOC) or depth of discharge (DOD) to indicate the charge level of the battery cell, state of health (SOH; a variously-defined measurement of the remaining capacity of the battery cell as % of the original capacity), state of power (SOP; the amount of power available for a defined time interval given the current power usage, temperature and other conditions), state of safety (SOS), maximum charge current as a charge current limit (CCL), maximum discharge current as a discharge current limit (DCL), and internal impedance of a cell (to determine open circuit voltage).

The BMS may be centralized such that a single controller is connected to the battery cells through a multitude of wires. In other examples, the BMS may be also distributed, with a BMS board is installed at each cell, with just a single communication cable between the battery cell and a controller. In yet other examples, the BMS may have a modular construction including a few controllers, each handling a certain number of cells, while communicating between the controllers. Centralized BMSs are most economical, but are least expandable, and are plagued by a multitude of wires. Distributed BMSs are the most expensive, but are simplest to install, and offer the cleanest assembly. Modular BMSs provide a compromise of the features and problems of the other two topologies.

The BMS may protect the battery pack from operating outside its safe operating area. Operation outside the safe operating area may be indicated by over-current, over-voltage (during charging), over-temperature, under-temperature, over-pressure, and ground fault or leakage current detection. The BMS may prevent the battery from operating outside its safe operating parameter by including an internal switch (e.g., a relay or solid-state device) that opens if the battery is operated outside its safe operating parameters, requesting the devices to which the battery is connected to reduce or even terminate using the battery, and actively controlling the environment, such as through heaters, fans, air conditioning or liquid cooling.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge, SoC, potential electrical performance, charging ability and internal resistance as well as actual or predicted power demands or surpluses of the consumers. Therefore, battery systems usually include a battery management system, BMS, for obtaining and processing such information on system level and further a plurality of battery module managers, BMMs, which are part of the system's battery modules and obtain and process relevant information on module level. Particularly, the BMS usually measures the system voltage, the system current, the local temperature at different places inside the system housing, and the insulation resistance between live components and the system housing. Additionally, the BMMs usually measure the individual cell voltages and temperatures of the battery cells in a battery module.

Thus, the BMS is provided for managing the battery pack, such as by protecting the battery from operating outside its safe operating area, monitoring its state, calculating secondary data, reporting that data, controlling its environment, authenticating it and/or balancing it.

In case of an abnormal operation state, a battery pack shall usually be disconnected from a load connected to a terminal of the battery pack. Therefore, battery systems further include a battery disconnect unit, BDU, that is electrically connected between the battery module and battery system terminals. Thus, the BDU is the primary interface between the battery pack and the electrical system of the vehicle. The BDU includes electromechanical switches that open or close high current paths between the battery pack and the electrical system. The BDU provides feedback to the battery control unit, BCU, accompanied to the battery modules such as voltage and current measurements. The BCU controls the switches in the BDU using low current paths based on the feedback received from the BDU. The main functions of the BDU may thus include controlling current flow between the battery pack and the electrical system and current sensing. The BDU may further manage additional functions like external charging and pre-charging.

An active or passive thermal management system may be included to provide thermal control of the battery pack, to safely use the at least one battery module by efficiently emitting, discharging, and/or dissipating heat generated from its rechargeable batteries. If the heat emission/discharge/dissipation is not sufficiently performed, temperature deviations may occur between respective battery cells, such that the at least one battery module may no longer generate a desired (or designed) amount of power. In addition, an increase of the internal temperature can lead to abnormal reactions occurring therein, and thus charging and discharging performance of the rechargeable battery deteriorates and the life-span of the rechargeable battery is shortened. Thus, cell cooling for effectively emitting/discharging/dissipating heat from the cells is required.

Exothermic decomposition of cell components may lead to a so-called thermal runaway. Generally, thermal runaway describes a process that accelerates due to increased temperature, in turn releasing energy that further increases temperature. Thermal runaway occurs in situations when an increase in temperature changes the conditions in a way that causes a further increase in temperature, often leading to a destructive result. In rechargeable battery systems, thermal runaway is associated with strong exothermic reactions that are accelerated by temperature rise. In thermal runaway, the battery cell temperature rises incredibly fast and the energy stored is released very suddenly. In extreme cases, thermal runaway can cause battery cells to explode and start fire. In minor cases, it can cause battery cells to be damaged beyond repair.

When a battery cell is heated above a critical temperature (for example, above 150°C) the battery cell can transition into a thermal runaway. Generally, temperatures outside of the safe region on either the low or high side may lead to irreversible damage to the battery cell and therefore may possible trigger thermal runaway. Thermal runaway may also occur due to an internal or external short circuit of the battery cell or poor battery maintenance. For example, overcharging or rapid charging may lead to thermal runaway.

During thermal runaway, the failed battery cell may reach a temperature exceeding 700°C. Further, large quantities of hot gas are ejected from inside of the failed battery cell through the venting opening of the cell housing into the battery pack. The main components of the vented gas are $H_2$, $CO_2$, CO, electrolyte vapor and other hydrocarbons. The vented gas is therefore flammable and potentially toxic. The vented gas also causes a gas-pressure to increase inside the battery pack. In the worst case, the high temperatures lead to the process spreading to neighboring cells and fire in the battery pack. At this stage, the fire is hardly to extinguish.

The BMS is critical to the safe operation and optimal performance of rechargeable battery cells and helps minimize the possibility of thermal runaway. For example, if the BMS detects that the temperature is too hot, it can regulate the temperature by controlling cooling fans. Alternatively, if the battery cell cannot be cooled and safe conditions restored, the BMS may shut down necessary battery cells to protect the entire system.

Lithium-ion cells show a critical behavior in the very old aging state, especially with a remaining capacity of less than 50% of the capacity present at the beginning, i.e. the begin of Life, BoL, capacity. Although defined operating limits are followed during aging, sudden failures of the cells occur. Such sudden failures are very difficult to detect because no measurable signal shows any behavior indicating this sudden failure. The operating limits for the cells are defined throughout the life of the cell until End-of-safe-operation, EoS is reached.

EP 4 026 729 A1 discloses a method for determining an action to be taken based on forecasted End-of-life, EoL, parameters for an electric Energy Storage System, ESS, and for an at least partly electric vehicle in which the electric ESS is comprised. An ESS parameter impacted by utilization of the at least one electric vehicle is obtained and a forecasted EoL ESS parameter is determined based on the at least one ESS parameter. Further, a vehicle parameter impacted by utilization of the at least one electric vehicle is obtained and a forecasted EoL vehicle parameter is determined based on the at least one vehicle parameter. The forecasted EoL ESS parameter and the forecasted EoL vehicle parameter are compared. If the forecasted EoL ESS parameter does not reach the forecasted EoL vehicle parameter or exceeds it, then an action is taken such that the forecasted EoL ESS parameter at least substantially corresponds to the forecasted EoL vehicle parameter.

US 2016/0221465 A1 discloses a method, wherein an actual aging state $SOH_{Ist}$ of an electrical energy storage device is monitored and determined and a target aging state $SOH_{Soll}$ of the electrical energy storage device is determined. The target aging state $SOH_{Soll}$ is given here by a defined aging curve over time. An allowed operating parameter range is then adjusted if a comparison of the actual aging state $SOH_{Ist}$ with the target aging state $SOH_{Soll}$ shows that the actual aging state indicates increased aging and/or decreased aging compared to the target aging state $SOH_{Soll}$. If increased aging is detected, the operating parameter range is adjusted so that operation of the electrical energy storage device within the adjusted operating parameter range takes place at a reduced aging rate, so that a return to the target aging curve is achieved or the actual aging state $SOH_{Ist}$ at least approaches the target aging curve.

## Summary of Invention

The invention is defined by the appended claims. The description that follows is subjected to this limitation. Any disclosure lying outside the scope of said claims is only intended for illustrative as well as comparative purposes.

According to one aspect of the present disclosure, a method for operating a battery pack is provided, including the steps of a) determining a current intermediate characteristic value characterizing an aging state degree of the battery pack based on detected and/or obtained condition measurement signal; b) performing a comparison of the current intermediate characteristic value and a first predetermined value of the intermediate characteristic value, wherein the first predetermined value includes a value of the intermediate characteristic value at which a predefined value of the aging state degree is undercut; and c) adjusting an operational limit for the battery pack based on the comparison.

According to another aspect of the present disclosure, a battery system is provided, including a battery pack including at least one battery cell; a measurement means or a communication interface for detecting and/or obtaining a condition measurement signal; and a control unit; wherein the control unit is configured for performing the following steps of a) determining a current intermediate characteristic value characterizing an aging state degree of the battery pack based on detected and/or obtained condition measurement signal; b) performing a comparison of the current intermediate characteristic value and a first predetermined value of the intermediate characteristic value, wherein the first predetermined value includes a value of the intermediate characteristic value at which a predefined value of the aging state degree is undercut; and c) adjusting an operational limit for the battery pack based on the comparison.

Further aspects of the present disclosure could be learned from the dependent claims or the following description.

## Brief Description of the Drawings

Features will become apparent to those of ordinary skill in the art by describing in detail exemplary embodiments with reference to the attached drawings in which:

Fig. 1 illustrates an operation curve of a battery pack and a corresponding capacity aging curve.

Fig. 2 illustrates a method for operating a battery pack according to an embodiment of the invention.

## Detailed Description of the invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art.

Accordingly, processes, elements, and techniques that are not considered necessary to those having ordinary skill in the art for a complete understanding of the aspects and features of the present disclosure may not be described. In the drawings, the relative sizes of elements, layers, and regions may be exaggerated for clarity.

As used herein, the term "and/or" includes any and all combinations of one or more of the associated listed items. Further, the use of "may" when describing embodiments of the present disclosure refers to "one or more embodiments of the present disclosure." In the following description of embodiments of the present disclosure, the terms of a singular form may include plural forms unless the context clearly indicates otherwise.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present disclosure. Expressions such as "at least one of," when preceding a list of elements, modify the entire list of elements and do not modify the individual elements of the list.

As used herein, the term "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of +/-5% of the value centered on the value.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

In the following description of embodiments of the present disclosure, the terms of a singular form may include plural forms unless the context clearly indicates otherwise.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. Further, the various components of these devices may be implemented on a flexible printed circuit film, a tape carrier package (TCP), a printed circuit board (PCB), or formed on one substrate. The electrical connections or interconnections described herein may be realized by wires or conducting elements, e.g. on a PCB or another kind of circuit carrier. The conducting elements may include metallization, e.g. surface metallizations and/or pins, and/or may include conductive polymers or ceramics. Further electrical energy might be transmitted via wireless connections, e.g. using electromagnetic radiation and/or light.

Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like.

Also, a person of skill in the art should recognize that the functionality of various computing devices may be combined or integrated into a single computing device, or the functionality of a particular computing device may be distributed across one or more other computing devices without departing from the scope of the exemplary embodiments of the present disclosure.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

General Concept

According to one aspect of the present disclosure, a method for operating a battery pack, is provided. Thereby a current intermediate characteristic value characterizing an aging state degree of the battery pack is determined based on detected and/or obtained condition measurement signal. Afterwards, a comparison of the current intermediate characteristic value and a first predetermined value of the intermediate characteristic value is performed, wherein the first predetermined value includes a value of the intermediate characteristic value at which a predefined value of the aging state degree is undercut. Further, an operational limit for the battery pack is adjusted based on the comparison.

Aging tests performed by the inventors under various conditions have shown internal cell defects of cells at a very high age, even though cells of the battery pack were operated under defined operating conditions. These cell defects not only lead to accelerated aging, as evidenced by a drop in a capacity aging curve, but also increase the likelihood that the cell will suddenly fail without warning. Such a situation can lead to potentially dangerous situations when these cells are operated in an application. The aforementioned internal cell defects cannot be measured directly by measurement signals available in the application, such as voltage, current or temperature. This is usually only possible by indirect calculation of the capacity and resistance rise, which is not possible in operation with the available measurement signal accuracy in the required safety quality.

Detection of the aging state degree of a cell can only be done in safety quality by measuring both capacity and resistance in a laboratory environment. By the invention, an intermediate characteristic value is used. This can be measured both in operation and under laboratory conditions with a very high precision and therefore provides the required safety quality.

This intermediate characteristic value refers to and characterizes an aging state degree of the battery pack, so that a knowledge of the aging state of the battery pack is available.

The aging state degree refers to the battery pack. According to an embodiment, this includes the capacity, i.e. the amount of energy stored in the battery pack. Accordingly, the current intermediate characteristic value refers to a current aging state degree, whereas the first predetermined value of the intermediate characteristic value refers to a first predetermined aging state degree.

According to an embodiment, the aging stage degree is characterized by the respective aging stage degree of battery modules and/or individual cells of the battery pack and especially by the most advanced aging stage of a battery module and/or a cell, if this differs from battery module to battery module and/or cell to cell. Thus, the intermediate characteristic value may at least determined for the smallest unit of the battery pack that is replaceable. This therefore depends on the structure of the battery pack. The smallest unit is often a battery module. Accordingly, the value at which a predefined value of the aging state degree is undercut may also described by this unit. For example, the battery pack includes several battery modules, of which only one has reached its value at which a predefined value of the aging state degree is undercut, but the others have not. Thus, for this one battery module the operational limit is adjusted or this one battery module defines the adjusting of the operational limit.

By comparing the current intermediate characteristic value and the first predetermined value of the intermediate characteristic value, both of which characterize an aging state degree, it is possible to make statements about reaching a specific age of the battery pack.

The first predetermined value includes a value of the intermediate characteristic value at which a predefined value of the aging state degree is undercut. In other words, the first predetermined value refers to a specific aging state degree of the battery pack. In other words, this may be an age to be defined at which a predefined value of the aging state degree is undercut with a probability that is also to be predetermined. According to an embodiment, the first predetermined value refers to an end-of-life, EoL. This may be a percentage value of the capacity of a new battery pack that initially has a capacity of 100%. For example, the first predetermined value refers to a value of 90% to 70%, 85% to 76% and 80% of the original capacity of the battery pack.

The invention provides a way to ensure the safety of battery packs - even in old age - by measuring an intermediate characteristic during operation and comparing it to a threshold value, the first predetermined value of the intermediate characteristic value.

Battery packs equipped with cells are usually operated in the state of the art in a first application up to a defined end-of-life, EoL. End-of-life is a term for the point in time at which previously defined values of a battery are undercut by aging. Further use is not prevented, so the packs continue to be operated up to another end-of-life and further to the end-of-safe-operation, EoS. At EoS, the use of the battery is prevented for safety reasons. Thus, operational limits for the battery pack are usually defined in the state of the art only up to the end-of-life, EoL, but not up to the end-of-safe-operation, EoS. Nevertheless, the operational limits are used throughout the life of the battery pack until EoS is reached. Using the battery pack in the full operating range after EoL can lead to overloading of the battery pack in a very aged state, further accelerating the aging process. These operational limits are designed based on aging data of the cell up to EoL and can lead to an overload of the cell if it is used in its full operating range after EoL.

The invention provides functionality that prevents overloading of the battery pack when operating. Consequently, functionality is provided that reduces stress by scaling an operational limit as a function of battery pack aging based on the comparison of the current intermediate characteristic value and the first predetermined value of the intermediate characteristic value, wherein the first predetermined value includes a value of the intermediate characteristic value at which a predefined value of the aging state degree is undercut, potentially extending lifetime by delaying the time of end-of-safe-operation.

According to one embodiment, the comparison further includes performing a comparison of the current intermediate characteristic value and a second predetermined value of the intermediate characteristic value, wherein the second predetermined value includes a value of the intermediate characteristic value at which a sudden cell failure is expected, for identifying an end-of-safe-operation, EoS, of the battery pack. Detection of the risk for the described cell defects in an aged cell can only be done in safety quality by measuring both capacity and resistance in a laboratory environment. By the embodiment, an intermediate characteristic value is used. This can be measured both in operation and under laboratory conditions with a very high precision and therefore provides the required safety quality. The second predetermined value includes a value of the intermediate characteristic value at which a sudden cell failure is expected. In other words, the second predetermined value refers to an end-of-safe-operation, EoS. In other words, this may be an age to be defined at which a cell failure is expected with a probability that is also to be predetermined. According to an embodiment, this is a percentage value of the capacity of a new battery pack that initially has a capacity of 100%. For example, the second predetermined value refers to a value of 70% to 50%, 60% to 50% and 55% to 50% of the original capacity of the battery pack. Additionally or alternatively, the intermediate characteristic value at which a sudden cell failure is expected is defined based on experimentally determined probabilities for a cell failure. According to an embodiment, the probability of cell failure includes 20 - 70%, 30 - 60%, and 35 - 45%. In other words, the value of the intermediate characteristic value is thus defined as the second predetermined value of the intermediate characteristic value at which a cell failure is expected with one of the stated probabilities. By comparing the current intermediate characteristic value and the second predetermined value of the intermediate characteristic value, both of which characterize an aging state degree, it is possible to make statements about reaching the end-of-safe-operation due to cell aging-related internal cell defects and thus increased probability of sudden cell failure. It is ensured by this embodiment that the load is reduced by adjusting the operational limit as a function of the aging of the cell between the first and second predetermined value of the intermediate characteristic value, potentially extending the life, and identifying the time when the probability of cell failure is increased.

According to a further embodiment, the second predetermined intermediate characteristic value includes a higher value of the characteristic compared to another second predetermined intermediate characteristic value at which the operational limit remain constant. It is considered here that the service life of the battery pack is extended by the method according to the invention. If a predetermined predetermined intermediate characteristic value were used which was predetermined without using this method, the possible service life now extended by the method would not be utilized to the full extent. Especially in combination with the embodiment aiming at identifying the EoS, synergistic effects can be achieved by extending the lifetime and detecting the EoS and an optimized operation can be realized.

According to another embodiment, the operational limit includes an operational current limit, operational voltage limit and/or an operational temperature limit. By adjusting at least one of these operational limits, the load on the cell is reduced and the EoS is shifted, or in other words, the lifetime is extended. Preferably, several operational limits and particularly preferably all of the operational limits mentioned are adjusted.

In another embodiment of the present disclosure, the adjusting further includes increasing or decreasing of a maximum value and/or a minimum value of the operational limit. Depending on the specific application, the minimum value may be adjusted by increasing or decreasing it and/or the maximum value is adjusted by increasing or decreasing it. This results in a targeted adaptation of the operating parameters and improved operation of the battery pack.

In a further embodiment, the adjusting further includes continuous narrowing of an interval between a maximum value and a minimum value of the operational limit. Accordingly, a minimum value for the operational limit and an upper maximum value for that operational limit are set and an interval between them is adjusted. Depending on the specific application, the lower minimum value may be adjusted by increasing or decreasing it and/or the upper maximum value is adjusted by increasing or decreasing it. For example, in case of an operational voltage limit, the minimum value of the operational voltage limit is increased and the maximum value of the operational voltage limit is decreased. The same applies to an operational current limit and an operational temperature limit. This results in a targeted adaptation of the operating parameters and improved operation of the battery pack. The narrower interval compared to the initial condition avoids fluctuation of the operational limit and consequently ensures "milder" operation of the battery pack, further extending its service life.

According to another embodiment, the continuously narrowing is a linear and/or exponential narrowing. Due to a linear narrowing, the operational limit is also continuously and monotonically adjusted as the battery pack ages. Accordingly, a uniform adaptation to the aging state takes place, whereby the effects of an increasing aging state are continuously mitigated. An exponential narrowing considers that cell defects become more and more probable with increasing aging or that they are increasingly prevented by progressive adaptation of the operational limit.

Further, the linear narrowing may be based on the current intermediate characteristic value and/or a deviation between the current intermediate characteristic value and a second predetermined intermediate characteristic value, wherein the second predetermined value includes a value of the intermediate characteristic value at which a sudden cell failure is expected. This results in an adjustment of the operational limit depending on the aging state degree of the battery pack. In other words, the dependence of the scaling on the age is achieved by coupling the scaling to the current intermediate characteristic value or to the capacity aging estimated by the method.

According to one embodiment the method further includes outputting a warning message and/or locking the battery back when the end-of-safe-operation of the battery pack is identified. The occurrence of sudden cell failures can lead to safety-relevant situations. In this respect, information is provided in the form of a warning, which prompts a user to take further action and enables appropriate intervention at the right time. By locking the battery pack, action is taken immediately and the risk of consequential damage due to continued operation and a resulting failure is significantly reduced. In other words, the battery pack is locked when cells of the battery pack have reached a level of usage at which it is no longer ensured that the battery pack can be operated safely.

According to another embodiment, the method further includes determining a deviation between the current intermediate characteristic value and the second predetermined value of the intermediate characteristic value. This enables one for identifying the end-of-safe-operation of the battery pack based on a result of the determined deviation.

In another embodiment of the present disclosure, the method further includes performing a comparison of the determined deviation to a first threshold value. The first threshold value may be an absolute and/or a relative threshold value. In case of an absolute threshold value, consequently a distance between the current intermediate characteristic value and the second predetermined value of the intermediate characteristic value is monitored in the form of the deviation and this distance is compared with the first threshold value. In case of a relative threshold value the threshold value may be a percentage value representing a percentage deviation defined by the user and deemed permissible. This means that an absolute distance adapted to an application or the battery pack does not have to be defined each time. Instead, a deviation can be defined in the form of a percentage. In this case, the second predetermined value of the intermediate characteristic value defines the 100% and, based on this, the percentage deviation between the current intermediate characteristic value and the second predetermined value of the intermediate characteristic value is calculated and compared with a predetermined percentage limit value.

In a further embodiment, the method further includes determining the end-of-safe-operation of the battery pack when the deviation falls below the first threshold value. Since the current intermediate characteristic value characterizes the aging state degree, which is constantly increasing, the current intermediate characteristic value is also constantly increasing. Accordingly, a distance between the current intermediate characteristic value and the second predetermined value of the intermediate characteristic value decreases. The first threshold value defines a distance between the two values which is tolerable, for example. Due to aging, however, this distance is undershot at a certain point and the current intermediate characteristic value approaches the second predetermined value of the intermediate characteristic value. Consequently, the deviation falls below the first threshold value at a certain aging point. Based on this point, it is now possible to reliably and accurately detect the end-of-safe-operation of the battery pack and safe operation is enabled.

In a further embodiment of the present disclosure, the method further includes steps of performing a comparison of the deviation to the first threshold value and a second threshold value, outputting a warning message if the deviation falls below the first threshold value and locking the battery pack if the deviation falls below the first threshold value and the second threshold value. Accordingly, it is first determined whether the aging state degree of the battery pack is approaching the safety-relevant range by marking this range with the first threshold value. A user, for example, is informed of this and can take action if necessary or arrange for more attentive monitoring of the battery pack in question. In addition, the battery pack is locked if it also falls below the second threshold value, preventing critical operation of the battery pack. This implements a multi-level safety system and provides detailed information about several levels of critical areas of the battery pack.

According to another embodiment, the intermediate characteristic value includes an energy throughput, ETP. The ETP can be measured with a very high precision both in operation and under laboratory conditions and therefore provides a required safety quality and thus represents a particularly suitable intermediate characteristic value characterizing the aging condition.

Further, the detected and/or obtained condition measurement signal may include a voltage, a current, and/or an elapsed time of the battery system. Voltage u and current i may be monitored at a module level, but can also be monitored at the pack or a cell level. The intermediate characteristic is not limited to ETP. However, voltage, current, and/or elapsed time t are monitored, as the intermediate characteristic is usually positively correlated with these and can therefore be determined from the condition measurement signal. In case of a battery module as smallest unit of the battery pack, the voltage resulting from single battery cells of a battery module of the battery pack may be used. This is then used to determine for example the ETP of a battery module of the battery pack. Often the battery modules of the battery pack are connected in series so that the current through them is the same. The total ETP is then determined for each module of the battery pack. This enables one, to adjust the operational parameters for the individual battery module and/or to lock the battery pack and change the smallest unit that is replaceable, whose end-of-safe-operation is identified.

According to another embodiment, the elapsed time is measured independently of the current. For example, if the battery pack is not used, no current flows at all, so that an intermediate characteristic value such as ETP would not increase, but the cells would still age due to the pure elapsed time. This is considered by this design, so that an even more precise picture of the aging state degree of the battery pack is available.

According to another embodiment, the ETP is determined by

$$ETP = \int_0^t u * i \, dt.$$

With this rule, based on the condition measurement signal, the ETP can be precisely determined by the accumulation of the ETP in each unit of time. Here u represents the time-dependent voltage and i the time-dependent current provided by the battery pack. In case of a battery module as smallest unit of the battery pack, the voltage u and current i provided by single battery cells of a battery module of the battery pack are used alternatively. When applying the above formula, it should be noted that there are various known methods for determining the result based on the above rule. A simple example to illustrate this is the combination of calculating the mean value of the aforementioned variables within a time interval delta t and the trapezoidal rule when measuring at discrete points in time. The arithmetic mean of the value is determined using the measured values $u_{i-1}$ and $u_i$ or $i_{i-1}$ and $i_i$ at the time points $t_{i-1}$ and $t_i$ and the integral is then calculated by multiplying by the time interval delta t. This is carried out for all measured values and thus the integral is calculated approximately. In other words, the above formula represents the exact calculation rule, which is then applied to the practical application using known mathematical methods.

The condition measurement signal may be measured during a charging operation and discharging operation. The battery pack also ages to a certain extent during these processes. By taking this into account, the reliability of a statement on the aging state degree based on the method according to the invention increases.

According to a further embodiment, the first and/or second predetermined value of the intermediate characteristic value is predetermined in a laboratory environment based on a same type of battery cell that is used in the battery pack. For the use of the first and/or second predetermined value of the intermediate characteristic value as part of the aging benchmark, the corresponding limit value for the corresponding value of the intermediate characteristic value must be defined. According to this embodiment, this definition is done by aging cells in test laboratories under different reference conditions and under compliance with defined operational limits, for example, until a point in time when previously defined values of a battery are undercut due to aging. For example, until an EoL and/or a knee effect is observed and/or until cell failures occur more frequently, so that this point characterizes an increased probability of cell failure. During this aging process, the intermediate characteristic value, for example the ETP, is accumulated. The intermediate characteristic value until the said characteristic points are reached under reference conditions is used to define the value of the intermediate characteristic value at which a predefined value of the aging state degree is undercut and/or the EoS is reached and thus the first and/or second predetermined value of the intermediate characteristic value is determined. The first and/or second predetermined value of the intermediate characteristic value is used in operation to estimate the remaining usage time of the cell and. for example, to lock the battery pack to prevent further usage, when EoS is reached. The knee effect describes accelerated capacity aging and signals that cell aging-related internal cell defects increase the probability of sudden cell failure. According to an embodiment, a cell test continues even after the knee effect has occurred to monitor behavior after the knee effect has set in. This provides some assurance that the cell can still be operated once the knee effect has set in. This allows for tolerance ranges to be considered, for example in conjunction with use of first and second threshold values. The first and/or second predetermined value of the intermediate characteristic value may include a value of a characteristic curve, for example, a capacity curve of the battery pack, at which a certain capacity of the battery pack is undercut and/or a knee effect of a battery cell starts.

In a further embodiment of the present disclosure, the second predetermined value of the intermediate characteristic value includes a value of the intermediate characteristic value at which a vent valve of a respective battery cell of the battery pack opens. In other words, this represents a point at which a cell of the battery pack begins to degas, thereby also providing a suitable characteristic by which a critical region is defined in terms of the EoS.

According to a further embodiment, the first and/or second predetermined value of the intermediate characteristic value is adjusted during operation of the battery pack depending on the usage of the specific battery pack, an aging feedback from a field with a plurality of battery packs of the same type of battery pack, and/or an application of the battery pack. In other words, consideration is given to whether, for example, harsh or mild conditions exist that cause premature onset of knee effect or earlier than originally predicted cell failures, or conversely, delayed onset of knee effect or later than originally predicted cell failures. This adjusts the first and/or second predetermined value of the intermediate characteristic value by considering the operating conditions so that an adjusted procedure is performed. The same applies to specific applications of the battery pack to reflect requirements and benefits of changing and different applications, for example, first-life applications, second-life applications, and third-life applications.

Specific Embodiments

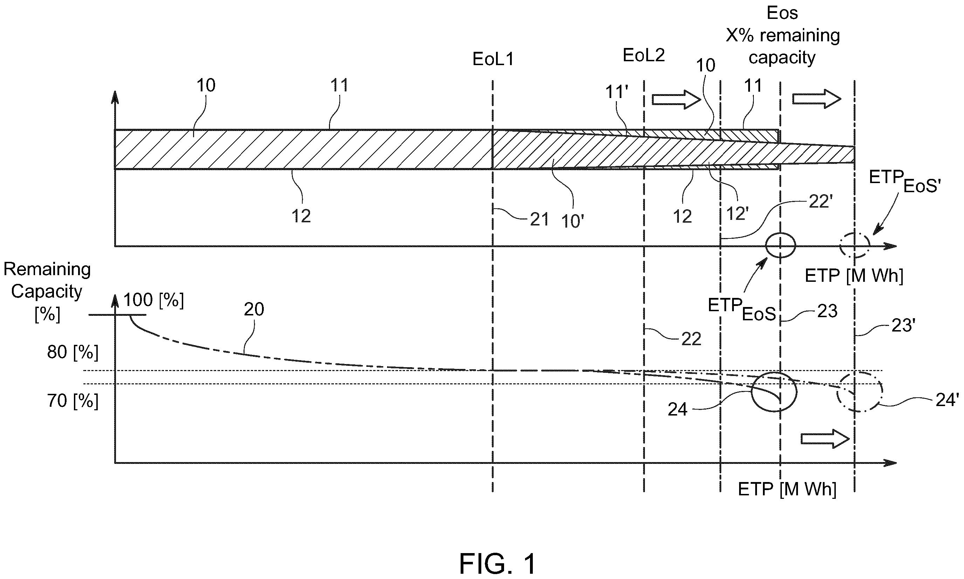

The upper part of Fig. 1 illustrates the course of an exemplary operation curve of a battery pack 10. In this example, the battery pack is operated within an operational limit range, as shown by the curve 10 plotted against the ETP. The operational limit includes an operational current limit, an operational voltage limit and/or an operational temperature limit. The lower part of Fig. 1 shows a capacity aging curve of the battery pack 20 corresponding to the operation curve 10. Here, the capacity is the amount of energy that can be stored in the battery pack. At the beginning of its initial operation, begin of life, BoL, it is assumed that the capacity of the battery pack is 100%. During operation, the battery pack provides energy for applications or absorbs energy in the case of a charging process. Both mechanisms result in aging of cells of the battery pack. The capacity of the battery pack - i.e. the amount of energy that can be extracted - decreases in the course of use. In the case of lithium-ion batteries, it even decreases in part over time without being used, which is referred to as the calendar life. This is also represented by the corresponding capacity aging curve 20. At the beginning, the capacity decreases with an initially steep negative slope, with the amount of the slope decreasing during progressive operation.

The battery pack is operated within the range of the operational limit. This range is limited by an upper limit and a lower limit and forms an interval between the upper and lower limit. The upper limit is the maximum value of the operational limit 11, 11' and the lower limit is the minimum value of the operational limit 12, 12'.

A dashed vertical line furthest to the left indicates the point at which a predefined value of an aging state degree is undercut, also known as first end-of-life, EoL1, 21. The end-of-life does not necessarily mean that a battery no longer functions. It is only usual to define parameters for a battery pack that must not be exceeded or fallen short of. In the present case, the parameter is the capacity, which is specified here as 80% for the first end-of-life 21. Furthermore, a second end-of-life 22, 22' is shown, for which a capacity of 70% is assumed. Battery packs, especially lithium ion cells, have shown critical behavior in very old aging state, in particular with a remaining capacity of less than 50% of the begin of life capacity. Although defined operational limits have been considered during aging, sudden failures of the cells can occur. Such sudden failures are very hard to detect, because no measurable signal is showing a behavior which is indicating this sudden failure.

In the further course, a region of the corresponding capacity aging curve 20 is recognizable, which is characterized by significantly larger negative slopes of the curve. This is where a so-called knee effect 24, 24' occurs, indicated by the respective dashed vertical line 23, 23'. The knee effect 24, 24' describes an accelerated capacity aging and signals that the cell aging-related internal cell defects increase the probability of a sudden cell failure. According to the invention, this range is used to define a time at which a sudden cell failure is expected, for identifying an end-of-safe-operation, EoS, 23, 23' of the battery pack or in other words, the state of the battery pack 10 in which a safe operation cannot be guaranteed anymore.

In the present case, Fig. 1 also illustrates the course observed during a laboratory test, which is used to determine a first and a second predetermined value of the intermediate characteristic value used within the method according to the invention. In other words, the first and second predetermined value of the intermediate characteristic value are predetermined in a laboratory environment based on using a same type of battery cell that is used in the battery pack.

Thus, an intermediate characteristic value such as the energy throughput, ETP, in the present embodiment is required for this purpose. The ETP can be measured with a very high precision both in operation and under laboratory conditions and therefore provides the required safety quality. This process is also described by Fig. 1.

For the use of ETP as an aging benchmark, a corresponding limit value of ETP for EoL1 and for EoS', hereinafter referred to as $ETP_{EoL1}$ and $ETP_{EoS'}$, must be defined. This then represents the first and second predetermined value of the intermediate characteristic value. This definition is done by aging cells in a test laboratory under different reference conditions and respecting defined operational limits until the knee effect is observed. The cell test itself is continued to monitor behavior after the knee effect has set in. This provides some assurance that the cell can still be operated once the knee effect has set in.

During this aging process, the ETP is accumulated. The ETP until the value at which a predefined value of the aging state degree is undercut and until the knee effect is reached under reference conditions is then used to define the EoL and EoS. This $ETP_{EoL1}$ and $ETP_{EoS'}$ is then used in the method of the invention to adjust the operational limit and to estimate the remaining time of use of the cell and to lock the battery pack to prevent further use.

Figure 1 shows two scenarios. The EoL1 21 and thus the corresponding $ETP_{EoL1}$ is identical for both scenarios. Until EoL1 is reached, the operational limit is the same in both cases, so there is no deviation. However, the operation after reaching Eol1 21 is also shown.

According to the first scenario, which corresponds to the state of the art and is associated with unchanged operational limits, it can be seen that the maximum value of the operational limit with a constant operational limit 11 and the minimum value of the operational limit with a constant operational limit 12 are unchanged until the EoS is reached. Accordingly, the operation curve of the battery pack 10 exhibits a characteristic second end-of-life, EoL2, with the constant operational limit 22, a characteristic end-of-safe-operation, EoS, with the constant operational limit 23 and a characteristic knee effect with a constant operational limit 24. The Eol2 22, the EoS 23 and the knee effect 24 are accompanied by corresponding values for the ETP.

In contrast, the second scenario corresponds to a method or laboratory test according to the invention, in which the operational limits are adjusted. The maximum value of an operational limit with an adjusted operational limit 11' and the minimum value of an operational limit with an adjusted operational limit 12' are adjusted according to the invention after the EoL1 21 has been reached, whereby in the present case the maximum value of the operational limit with an adjusted operational limit 11' is reduced and the minimum value of the operational limit with an adjusted operational limit 12' is increased. Accordingly, the operating curve of the battery pack 10 after reaching EoL1 has a different operating curve of the battery pack 10'. It further has a shifted characteristic second end-of-life, EoL2', with the adjusted operational limit 22', a shifted characteristic end-of-safe-operation, EoS', with an adjusted operational limit 23' and a shifted characteristic knee effect with an adjusted operational limit 24'. The shifted Eol2' 22', the shifted EoS' 23', and the shifted knee effect 24' are accompanied by corresponding values for the ETP. Compared to the first scenario according to the prior art, all mentioned characteristic points are shifted to higher values of the ETP, thus start later.

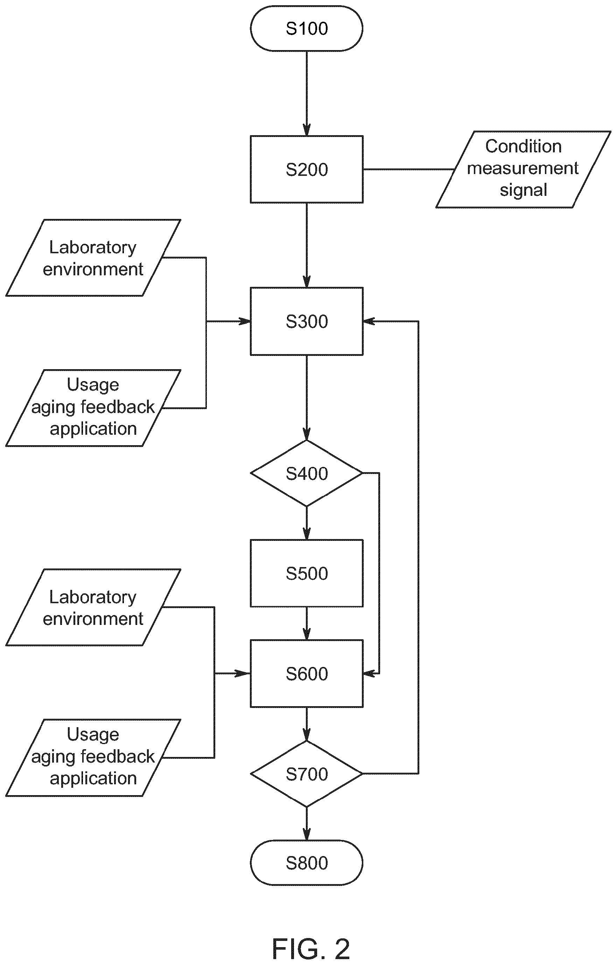

Fig. 2 illustrates a method for operating a battery pack according to an embodiment of the invention. In a first step S100 the operating of the battery pack starts.

Subsequently, in step S200 a current intermediate characteristic value is determined. The ETP can be measured with a very high precision both in operation and under laboratory conditions and therefore provides a required safety quality and thus represents a particularly suitable intermediate characteristic value characterizing the aging condition. According to the present embodiment, a detected and/or obtained condition measurement signal includes a voltage u, a current i, and an elapsed time of the battery system. Voltage u and current i may be monitored at a module level, but can also be monitored at the pack or a cell level. Voltage u, current i, and/or elapsed time are monitored as the intermediate characteristic and are usually positively correlated with these and can therefore be determined from the condition measurement signal. The ETP is determined by

$$ETP = \int_0^t u * i \, dt$$

Then in step S300 the current intermediate characteristic value ETP and a first predetermined value of the intermediate characteristic value are compared with each other. The first predetermined value of the intermediate characteristic value is in this case the value of the ETP corresponding to EoL1 21, which was explained in the context of Fig. 1 and whose determination was described under a laboratory environment.

In step S400 the comparison condition is checked. It is conceivable that the current intermediate characteristic value has an ETP that corresponds to or exceeds the ETP at the first end-of-life 21 representing the first predetermined value of the intermediate characteristic value. This comparison may be made by comparing the current intermediate characteristic value with an $ETP_{EoL1}$ determined during the laboratory test at the time of the first EoL 21. If the current intermediate characteristic value exceeds the $ETP_{EoL1}$, continued operation can occur.

The method is then continued in step S500. The operational limit is adjusted as also shown and explained in Figure 1. Accordingly, the maximum value of the operational limit with an adjusted operational limit 11' and the minimum value of an operational limit with an adjusted operational limit 12' are specified. Both are continuously adjusted during further operation by reducing the maximum value of the operational limit with an adjusted operational limit 11' and increasing the minimum value of an operational limit with an adjusted operational limit 12', thus reducing the interval between the two.

In an alternative scenario it is conceivable that the current intermediate characteristic value has an ETP that is below the ETP at the first end-of-life 21 representing the first predetermined value of the intermediate characteristic value. Therefore, starting from the comparison condition in step S400, the operational limit is not yet adjusted according to the invention.

In both cases, step S600 follows either directly after step S400 or after step S500. In step S600 the current intermediate characteristic value ETP and a second predetermined value of the intermediate characteristic value are compared with each other. The second predetermined value of the intermediate characteristic value is in this case the ETP that corresponds to or exceeds the ETP at the end-of-safe-operation 23', which was explained in the context of Fig. 1 and whose determination was described under a laboratory environment. Here it is important to note that explicitly the ETP is used as the second predetermined value of the intermediate characteristic value, which was predetermined under the assumption of the adjustment of the operational limit. According to an embodiment, a deviation between the current intermediate characteristic value and the second predetermined value of the intermediate characteristic value is determined by difference formation. This can then be present as an absolute difference and used in the further procedure or in the form of a relative deviation with respect to the $ETP_{EoS'}$.

In step S700 the comparison condition is checked. It is conceivable that the current intermediate characteristic value has an ETP that is below the second predetermined value of the intermediate characteristic value. This means that no cell failure is to be expected and further operation of the battery pack is possible. Accordingly, steps S300 and the following steps are repeated in this scenario.

In another scenario, an ETP is now determined for the current intermediate characteristic value that exceeds the second predetermined value of the intermediate characteristic value. This means that the battery pack has reached the point in time or the age at which there is an increased probability of cell failure. Therefore, to avoid a problematic situation, the comparison condition in step S700 is used to determine that the current intermediate characteristic value exceeds the $ETP_{EoS}$, and the battery pack is locked.

According to an embodiment, the first and second predetermined value of the intermediate characteristic value are adjusted during operation. Accordingly, the limit values are adjusted during the life of the battery pack to account for aging feedback from a field and to reflect requirements and benefits of changing and different applications. These include, for example, first-life application, second-life application, third-life application, extra mild application, extra harsh application, restricted temperature range application, and the like. In other words, the first and second predetermined value of the intermediate characteristic value are redefined or updated on an ongoing basis, for example, depending on the requirements of different applications.

Reference signs

| | |
|---|---|
| 10 | operation curve of a battery pack |
| 11 | maximum value of an operational limit with a constant operational limit |
| 11' | maximum value of an operational limit with an adjusted operational limit |
| 12 | minimum value of an operational limit with a constant operational limit |
| 12' | minimum value of an operational limit with an adjusted operational limit |
| 20 | capacity aging curve of a battery pack |
| 21 | first end-of-life, EoL1, |
| 22 | second end-of-life, EoL2, with a constant operational limit |
| 22' | second end-of-life, EoL2', with an adjusted operational limit |
| 23 | end-of-safe-operation, EoS, with a constant operational limit |
| 23' | end-of-safe-operation, EoS', with an adjusted operational limit |
| 24 | knee effect with a constant operational limit |
| 24' | knee effect with an adjusted operational limit |
| $ETP_{EoS'}$ | ETP at end-of-safe-operation, EoS, with an adjusted operational limit |
| S100 | operating a battery pack |
| S200 | determining a current intermediate characteristic value |
| S300 | performing a comparison of the current intermediate characteristic value and a first predetermined value of the intermediate characteristic value |
| S400 | comparison condition |
| S500 | Adjusting an operational limit based on the comparison |
| S600 | performing a comparison of the current intermediate characteristic value and a second predetermined value of the intermediate characteristic value |
| S700 | comparison condition |
| S800 | locking the battery back |

**Claims**

1. A method for operating a battery pack, including the steps of:

   a) Determining a current intermediate characteristic value characterizing an aging state degree of the battery pack based on detected and/or obtained condition measurement signal;
   b) Performing a comparison of the current intermediate characteristic value and a first predetermined value of the intermediate characteristic value, wherein the first predetermined value includes a value of the intermediate characteristic value at which a predefined value of the aging state degree is undercut; and
   c) Adjusting an operational limit for the battery pack based on the comparison.

2. Method according to claim 1, wherein the comparison further includes:
   Performing a comparison of the current intermediate characteristic value and a second predetermined value of the intermediate characteristic value, wherein the second predetermined value includes a value of the intermediate characteristic value at which a sudden cell failure is expected, for identifying an end-of-safe-operation, EoS, of the battery pack.

3. Method according to claim 2, wherein the second predetermined intermediate characteristic value includes a higher value of the characteristic compared to another second predetermined intermediate characteristic value at which the operational limit remain constant.

4. Method according to any one of the preceding claims, wherein the operational limit includes an operational current limit, operational voltage limit and/or an operational temperature limit.

5. Method according to any one of the preceding claims, wherein the adjusting further includes:
   Increasing or Decreasing of a maximum value and/or a minimum value of the operational limit.

6. Method according to any one of the preceding claims, wherein the adjusting further includes:
   continuous narrowing of an interval between a maximum value and a minimum value of the operational limit.

7. Method according to claim 6 wherein the continuously narrowing is a linear and/or exponential narrowing.

8. Method according to claim 7, wherein the linear narrowing is based on the current intermediate characteristic value and/or a deviation between the current intermediate characteristic value and a second predetermined intermediate characteristic value, wherein the second predetermined value includes a value of the intermediate characteristic value at which a sudden cell failure is expected.

9. Method according to any one of the preceding claims, wherein the intermediate characteristic value includes an energy throughput, ETP.

10. Method according to any one of the preceding claims, wherein the detected and/or obtained condition measurement signal includes a voltage, a current, and an elapsed time of the battery system.

11. Method according to claim 9, wherein the time is measured independently of the current.

12. Method according to claims 9 and 10 or 11, wherein the ETP is determined by $ETP = \int_0^t u * i \, dt$.

13. Method according to any one of the preceding claims, wherein the condition measurement signal is measured during a charging operation and discharging operation.

14. Method according to claim 1 and 2, wherein the first and/or the second predetermined value of the intermediate characteristic value is adjusted during operation of the battery pack depending on:

a usage of the specific battery pack,
an aging feedback from a field with a plurality of battery packs of the same type of battery pack, and/or
an application of the battery pack.

15. A battery system, including:

a battery pack including at least one battery cell;
a measurement means or a communication interface for detecting and/or obtaining a condition measurement signal; and
a control unit;
wherein the control unit is configured for performing the following steps of:

a) Determining a current intermediate characteristic value characterizing an aging state degree of the battery pack based on detected and/or obtained condition measurement signal;
b) Performing a comparison of the current intermediate characteristic value and a first predetermined value of the intermediate characteristic value, wherein the first predetermined value includes a value of the intermediate characteristic value at which a predefined value of the aging state degree is undercut; and
c) Adjusting an operational limit for the battery pack based on the comparison.

**Amended claims in accordance with Rule 137(2) EPC.**

1. A method for operating (S100) a battery pack, including the steps of:

a) Determining (S200) a current characteristic intermediate value characterizing an aging state degree (20), which includes a capacity, of the battery pack based on detected and/or obtained condition measurement signal;
b) Performing a comparison (S300) of the current characteristic intermediate value and a first predetermined value of the characteristic intermediate value, wherein the first predetermined value includes a value of the characteristic intermediate value at which a predefined value (21) of the aging state degree (20) is undercut and wherein the first predetermined value refers to a value of 90% to 70% of the original capacity of the battery pack; and
c) Adjusting (S500) an operational limit (11, 11', 12, 12') for the battery pack based on the comparison.

2. Method according to claim 1, wherein the comparison further includes:
Performing a comparison (S600) of the current characteristic intermediate value and a second predetermined value of the characteristic intermediate value, wherein the second predetermined value includes a value of the characteristic intermediate value at which a sudden cell failure is expected, for identifying an end-of-safe-operation ($ETP_{EoS'}$), EoS, of the battery pack.

3. Method according to claim 2, wherein the second predetermined characteristic intermediate value is higher compared to another second predetermined characteristic intermediate value at which the operational limit remains constant.

4. Method according to any one of the preceding claims, wherein the operational limit (11, 11', 12, 12') includes an operational current limit, operational voltage limit and/or an operational temperature limit.

**5.** Method according to any one of the preceding claims, wherein the adjusting further includes: Increasing or Decreasing of a maximum value and/or a minimum value of the operational limit (11, 11', 12, 12').

**6.** Method according to any one of the preceding claims, wherein the adjusting further includes: continuous narrowing of an interval between a maximum value and a minimum value of the operational limit (11, 11', 12, 12').

**7.** Method according to claim 6 wherein the continuously narrowing is a linear and/or exponential narrowing.

**8.** Method according to claim 7, wherein the linear narrowing is based on the current characteristic intermediate value and/or a deviation between the current characteristic intermediate value and a second predetermined characteristic intermediate value, wherein the second predetermined value includes a value of the characteristic intermediate value at which a sudden cell failure is expected.

**9.** Method according to any one of the preceding claims, wherein the intermediate characteristic value includes an energy throughput, ETP.

**10.** Method according to any one of the preceding claims, wherein the detected and/or obtained condition measurement signal includes a voltage, a current, and an elapsed time of the battery system.

**11.** Method according to claim 9, wherein the time is measured independently of the current.

**12.** Method according to claims 9 and 10 or 11, wherein the ETP is determined by $ETP = \int_0^t u * i \, dt$.

**13.** Method according to any one of the preceding claims, wherein the condition measurement signal is measured during a charging operation and discharging operation.

**14.** Method according to claim 1 and 2, wherein the first and/or the second predetermined value of the characteristic intermediate value is adjusted during operation of the battery pack depending on:

a usage of the specific battery pack,
an aging feedback from a field with a plurality of battery packs of the same type of battery pack, and/or
an application of the battery pack.

**15.** A battery system, including:

a battery pack including at least one battery cell;
a measurement means or a communication interface for detecting and/or obtaining a condition measurement signal; and
a control unit;
wherein the control unit is configured for performing the following steps of:

a) Determining (S200) a current characteristic intermediate value characterizing an aging state degree (20), which includes a capacity, of the battery pack based on detected and/or obtained condition measurement signal;
b) Performing a comparison (S300) of the current characteristic intermediate value and a first predetermined value of the characteristic intermediate value, wherein the first predetermined value includes a value of the characteristic intermediate value at which a predefined value (21) of the aging state degree (20) is undercut and wherein the first predetermined value refers to a value of 90% to 70% of the original capacity of the battery pack; and
c) Adjusting (S500) an operational limit (11, 11', 12, 12') for the battery pack based on the comparison.

FIG. 1

FIG. 2

**EUROPEAN SEARCH REPORT**

Application Number

EP 24 15 0212

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 562 555 A1 (HITACHI LTD [JP]) 27 February 2013 (2013-02-27) * abstract * * paragraphs [0005] - [0008], [0010] - [0096] * * figures 1-10 * | 1-10, 13-15 | INV. B60L58/10 B60L58/12 B60L58/16 G01R31/392 H01M10/44 H01M10/48 |
| X | US 2019/160948 A1 (LEGNEDAHL NIKLAS [SE] ET AL) 30 May 2019 (2019-05-30) * abstract * * paragraphs [0001] - [0127] * * figures 1-4b * | 1-12,14, 15 | |
| X | WO 2009/009758 A2 (A123 SYSTEMS INC [US]; CHIANG YET-MING [US] ET AL.) 15 January 2009 (2009-01-15) * abstract * * paragraphs [0002] - [0019], [0052] - [0109] * | 1-15 | |

TECHNICAL FIELDS
SEARCHED (IPC)

B60L
G01R
H01M

The present search report has been drawn up for all claims

| Place of search | Date of completion of the search | Examiner |
|---|---|---|
| The Hague | 4 June 2024 | Hagan, Colm |

EPO FORM 1503 03.82 (P04C01)

EP 4 582 304 A1

## ANNEX TO THE EUROPEAN SEARCH REPORT
## ON EUROPEAN PATENT APPLICATION NO.

EP 24 15 0212

04-06-2024

| Patent document cited in search report | | Publication date | Patent family member(s) | | Publication date |
|---|---|---|---|---|---|
| EP 2562555 | A1 | 27-02-2013 | CN | 102893170 A | 23-01-2013 |
| | | | EP | 2562555 A1 | 27-02-2013 |
| | | | JP | 5564561 B2 | 30-07-2014 |
| | | | JP | WO2011132311 A1 | 18-07-2013 |
| | | | KR | 20130004336 A | 09-01-2013 |
| | | | US | 2013088201 A1 | 11-04-2013 |
| | | | WO | 2011132311 A1 | 27-10-2011 |
| US 2019160948 | A1 | 30-05-2019 | CN | 109311396 A | 05-02-2019 |
| | | | EP | 3468830 A1 | 17-04-2019 |
| | | | US | 2019160948 A1 | 30-05-2019 |
| | | | WO | 2017215738 A1 | 21-12-2017 |
| WO 2009009758 | A2 | 15-01-2009 | CN | 102037601 A | 27-04-2011 |
| | | | EP | 2171791 A2 | 07-04-2010 |
| | | | JP | 5558349 B2 | 23-07-2014 |
| | | | JP | 2011517361 A | 02-06-2011 |
| | | | KR | 20100057605 A | 31-05-2010 |
| | | | TW | 200915640 A | 01-04-2009 |
| | | | US | 2009123813 A1 | 14-05-2009 |
| | | | US | 2012231308 A1 | 13-09-2012 |
| | | | WO | 2009009758 A2 | 15-01-2009 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 4026729 A1
- US 20160221465 A1